# EUROPEAN PATENT APPLICATION

(11) **EP 4 372 468 A1**
(43) Date of publication of application: **22.05.2024**
(21) Application number: 22208685.2
(22) Date of filing: 21.11.2022
(51) Int. Cl.: G03F 7/20

(54) **A METHOD FOR OPTIMIZING A PARAMETER APPLIED IN A SEMICONDUCTOR FABRICATION PROCESS INCLUDING A LITHOGRAPHY STEP**

(71) Applicant: Imec VZW, 3001 Leuven (BE)
(72) Inventor: Truffert, Mr. Vincent, 3001 Leuven (BE); Ausschnitt, Mr. Christopher, 3001 Leuven (BE)
(74) Representative: Patent Department IMEC

(57) **Abstract**

A metrology target pattern is produced by printing the metrology pattern multiple times, using standard lithography techniques, each time with a different setting of a contrast-related parameter, such as the focus setting of the scanner tool used in the lithography step. The metrology target pattern comprises multiple asymmetric marks, each mark including an array of regularly spaced features (8,21). The features have different design CDs for different marks. According to the invention, assessment of the pattern contrast for a given value of the contrast-related process parameter is based on the slope of the relation between the effective CD of the printed or etched mark features, or a parameter proportional thereto, and the design CDs of the mark features. A parameter proportional to the effective CD is the position of the centroid of the marks, which may be obtained from suitably designed targets using either an image-based or a diffraction-based optical metrology tool. The slope of the effective CD versus the design CD of the mark features has a higher sensitivity to a change in a contrast-related parameter such as the focus setting, compared to the effective CD of individual pattern features, and therefore allows a more accurate determination of the optimum parameter values.

## Description

### Field of the Invention

The present invention is related to semiconductor processing, in particular to the determination of the optimal setting for a parameter applied in a process for producing a device pattern on a substrate, said process including a lithographic processing step.

### State of the art.

In semiconductor manufacturing, the devices in the chip are built by combining multiple layers of patterns in various materials. Lithography tools and processes are used to initiate each patterning step by imaging mask patterns on resist coated wafers, in order to produce a resist pattern after development of the resist. This is followed by transferring the resist pattern to an underlying layer by a suitable etch process. For the highest density patterns (pitches below 70 nm), EUV scanner imaging in thin resist layers is required. The optimization of a number of process parameters is done by varying these parameters and evaluating the eventual quality of a given pattern. Optimum pattern quality is related to the maximization of the pattern contrast.

Various lithographic parameters have an effect on the contrast of the resist pattern and/or the eventual etched device pattern. Such parameters include the focus setting on the lithographic tool, the illumination source conditions, the resist type and the Mean Standard Deviation (MSD), which is the differential positioning error induced by desynchronization of the scanner reticle stage to the wafer stage. Etch process parameters may have a further influence on the contrast of the eventual device pattern.

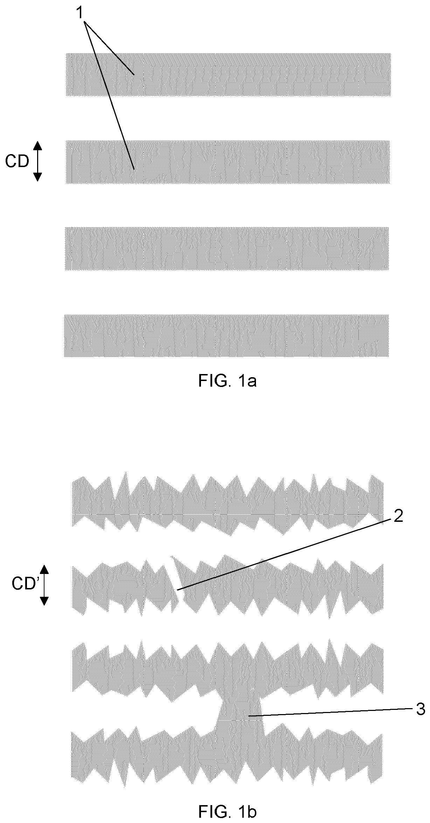

Pattern contrast is evaluated on the basis of a number of pattern attributes. For the thin resist layers used in EUV lithography, pattern attributes of the resist pattern may include : critical dimension (CD), line-edge roughness (LER), local CD uniformity (LCDU), and stochastic defect density (SDD). Figures 1a and 1b illustrate the difference between a resist pattern comprising four parallel line features 1, printed with good contrast, for example printed using the best focus setting (Fig. 1a) and bad contrast, for example printed at an out-of-focus setting (Fig. 1b). The first pattern has smooth edges and a CD (the width of the features) that is close to the design CD of the line features. The second pattern has rough edges (high LER), and by consequence a critical dimension CD' that varies in the longitudinal direction of the features (low LCDU). The pattern further includes stochastic defects, such as a line interruption 2 or a bridge 3 between adjacent lines. The number of such defects per unit area of the pattern yields the SDD value.

Today, the evaluation and optimization of the pattern contrast involves measuring one or more of the above pattern attributes on images of the pattern obtained by electron microscopy, also known as CD-SEM (critical dimension scanning electron microscopy). Evaluating the attributes on the basis of pattern images is however a time-consuming procedure. For the determination of best focus, which is usually the most important parameter to be optimized, an additional difficulty is the fact that lithographic masks are designed to print the pattern correctly in a focus range of interest. In other words, the critical dimension and other attributes are often not or very weakly dependent on focus variations within said focus range of interest. Nevertheless, the knowledge of the best focus is important as it indicates the centre of an applicable focus window within which pattern features can be produced correctly.

One way of obtaining a more accurate estimation of best focus is to determine the CD as a function of focus for different dose settings. This approach however signifies a further increase of the number of SEM image based CD measurements required, so that the method becomes even more time consuming. In addition, even when the dose is varied, the CD often remains insensitive to focus variations within the focus range of interest.

### Summary of the invention

The invention aims to provide a method for determining optimized parameter settings of a process for producing a device pattern, including a lithographic patterning step for patterning a resist layer, that does not suffer from the above-described drawbacks. This aim is achieved by the methods as disclosed in the appended claims. According to embodiments of the invention, a metrology target pattern is produced by printing the metrology pattern multiple times, using standard lithography techniques, each time with a different setting of a contrast-related parameter, such as the focus setting of the scanner tool used in the lithography step. The metrology target pattern comprises multiple asymmetric marks, each mark including an array of regularly spaced features. The features have different design CDs for different marks. The features can be line-space arrays whose design dimensions are varied only in the direction perpendicular to the line edge, or more complex two-dimensional arrays (e.g., contact holes, tip-to-tip designs, etc.) whose design dimensions are varied independently in each relevant direction.

According to the invention, assessment of the pattern contrast for a given value of the contrast-related process parameter is based on the slope of the relation between the effective CD of the printed or etched mark features, or a parameter proportional thereto, and the design CDs of the mark features. A parameter proportional to the effective CD is the position of the centroid of the marks, which may be obtained from suitably designed targets using either an image-based or a diffraction-based optical metrology tool.

The slope of the effective CD versus the design CD of the mark features has a higher sensitivity to a change in a contrast-related parameter such as the focus setting, compared to the effective CD of individual pattern features, and therefore allows a more accurate determination of the optimum parameter values. Preferred embodiments, such as the determination of the centroid position of the marks of a suitably designed metrology target, offer the additional advantage that the optimization can be done without requiring the measurement of pattern attributes (CD, LER, etc) in the obtained pattern. Parameter optimization thereby becomes possible not only more accurately, but also faster. As the optimization according to the method of the invention is largely independent of the dose setting of the scanner, measurements at different dose settings are not required, enabling an additional time saving compared to current methods.

The invention is in particular related to a method for optimizing a process parameter applicable in a process for producing a device pattern of a semiconductor component, the process comprising a lithography step and an etch step, the device pattern comprising device features formed on a substrate, said features being characterized by critical dimensions measurable in at least one direction, the method comprising the steps of :
- providing a lithographic mask that includes at least a metrology target pattern comprising a plurality of asymmetric marks, each mark comprising a solid portion and a pattern portion, the pattern portion comprising a regular array of equally dimensioned mark pattern features defined by a design CD (critical dimension) measurable in at least one direction, and wherein :
   ∘ the plurality of marks includes marks having different design CDs, which are offset on one or both sides with respect to a design CD value (w₀, w₀ₓ, w_{0y}) that is representative of one or more features of the device pattern,
   ∘ the effective CD of the mark features as reproduced in a resist pattern and in an etched pattern produced using said lithographic mask, or any parameter proportional thereto, exhibits a linear relation with respect to said different design CDs,
- reproducing the target pattern on a substrate, for a number of different settings of said process parameter,
- for each setting, determining the slope of said linear relation,
- optimizing the parameter by determining a setting that minimizes the slope.

The process for producing the device pattern comprises a lithography step and an etch step. The process used for reproducing the target pattern includes at least said lithography step, for reproducing the target pattern in the form of a resist pattern. The process used for reproducing the target pattern may further include the etch step, for reproducing the target pattern in the form of an etched pattern. As explained in the detailed description, optimization of the parameter may be done on the basis of a resist pattern or on the basis of an etched pattern, depending on which parameter is being optimized.

According to an embodiment, said process parameter is a parameter that can be represented by a numerical value, and the method includes the steps of :
- determining the best-fitting curve that connects the slopes as a function of the different numerical values representing the different applied parameter settings,
- determining a minimum of said best-fitting curve.

According to the latter embodiment, said process parameter may be the focus setting of a lithographic tool used for reproducing the target pattern, or said process parameter may be the Mean Standard Deviation (MSD), being the differential positioning error induced by desynchronization of the scanner reticle stage to the wafer stage of a lithographic tool used for reproducing the target pattern, wherein the MSD is varied by varying an overlay correction setting of the lithographic tool.

The method may further comprise determining the curvature of the best-fitting curve in one or more points of the curve, and deriving from said curvature information about process parameters other than the optimized parameter.

According to a further variant of the embodiment described in the preceding paragraph, the optimized parameter is the focus setting of a lithographic tool used for reproducing the target pattern, and the curvature is determined at the best focus setting, wherein said curvature is a measure of the depth of focus, in the sense that a smaller curvature indicates a higher depth of focus.

According to an embodiment:
- said process parameter is optimized for a plurality of sets of process conditions defined by varying one or more process parameters other than said optimized parameter, thereby obtaining a plurality of best-fitting curves corresponding respectively to said sets of conditions,
- the curvature of the best-fitting curves is determined in one or more points of the curves, and
- a selection of optimum conditions is made on the basis of said curvature.

According to an embodiment, the target pattern comprises at least one mark comprising an array of features having said design CD value (w₀, w₀ₓ, w_{0y}) that is representative of one or more features of the device pattern.

According to an embodiment, the marks include a one-dimensional array of line features defined by a critical dimension measurable in one direction.

According to an embodiment, the marks comprise a two-dimensional array of features defined by critical dimensions measurable in two orthogonal directions.

According to an embodiment, the marks of the target pattern are configured in such a way that the marks as reproduced on the substrate can be viewed by an optical tool, wherein the slope is determined by the following steps :
- with the optical tool, determining a parameter that is representative of the position of the centroid of the asymmetric marks, said parameter being proportional to the effective CD of the mark features,
- determining the slope as the slope of the linear relation between said parameter and the design CD.

According to an embodiment, the marks of the target pattern are arranged in the form of gratings configured so that the marks as reproduced on the substrate are suitable for use as diffraction gratings, wherein the plus and minus first order diffracted intensity of light diffracted by said diffraction gratings is measured, and wherein said slope is calculated from said measured intensities.

According to an embodiment, said method is performed on several die locations of a semiconductor process wafer, and a map is produced showing the optimized parameter for each die location on the wafer.

According to an embodiment, the optimized parameter is a lithographic process parameter of said lithography step, the target pattern is reproduced by said lithography step in the form of a resist pattern on the substrate, and the slope is determined by measurements performed on the resist pattern.

According to an embodiment, the optimized parameter is a lithographic process parameter of said lithography step or an etch process parameter of said etch step, the target pattern is reproduced by said lithography step followed by said etch step, in the form of an etched pattern on the substrate, and the slope is determined by measurements performed on the etched pattern.

### Brief description of the figures

Figures 1a and 1b illustrate the difference between a high and low contrast resist pattern in terms of a number of characteristic pattern attributes.
Figure 2 is a graph illustrating the dependence of the critical dimension of a line feature as a function of the focus setting of the scanner, for different values of the exposure dose.
Figure 3 is a detail of the graph of Figure 2, in a narrow focus range around the zero-defocus setting.
Figure 4 illustrates asymmetric marks included in a metrology target applicable according to an embodiment of the invention.
Figure 5 shows the linear relation of the effective CDs of the line features of the marks shown in Figure 4, as a function of the design CDs, for a number of focus settings.
Figure 6 is a graph of the slopes of the linear relations shown in Figure 5, as a function of the focus setting, and the best-fitting curve through the measured points.
Figure 7 illustrates the linear relation between a centroid-related parameter obtainable by an optical tool from the marks shown in Figure 4, and the design CDs of the respective line features of the marks.
Figure 8 illustrates a target design suitable for deriving the slope of the linear relation by a diffraction-based measurement.

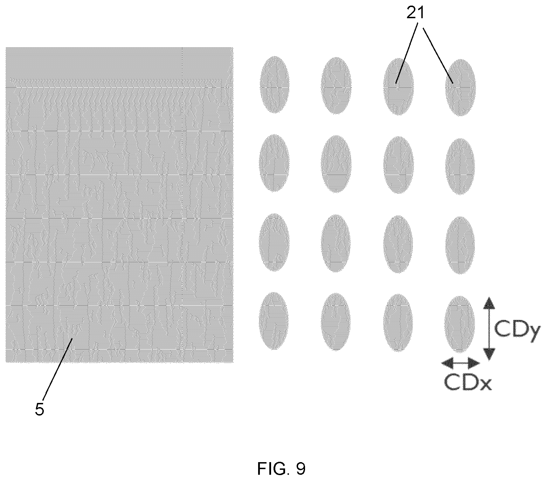

Figure 9 illustrates another typical mark design applicable in the method of the invention, including mark features defined by critical dimensions measurable in two orthogonal directions.

### Detailed description of the invention

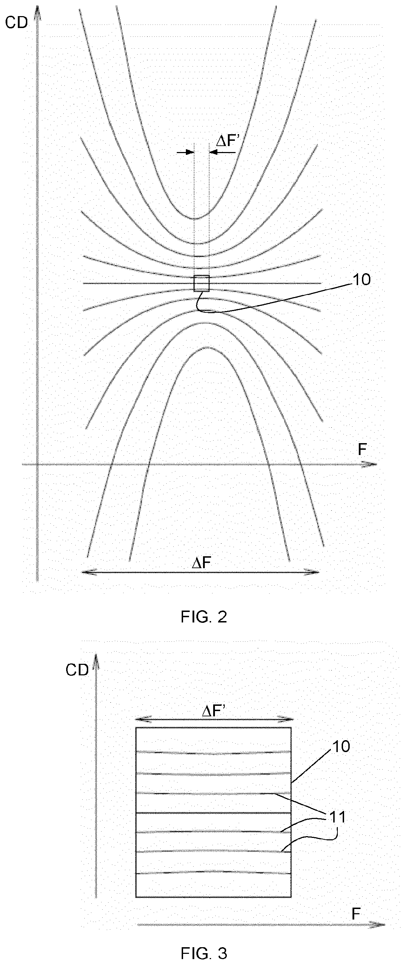

The problems highlighted in the introduction will first be explained in a little more detail, which will help to understand the way in which the present invention solves these problems. The graph in Figure 2 shows the general appearance of the relationship between the critical dimension of a typical pattern feature, for example the nano-sized width of a line feature of a resist pattern obtained by EUV lithography, and the focus setting of the scanner tool used in the lithography process, in a focus range ΔF.

As known in the art, the focus setting of the scanner corresponds to the deviation from a pre-defined zero-defocus setting, expressed for example in nm. Each curve in Figure 2 corresponds to a different dose setting of the tool with increasing dose from the bottom curve to the top curve. The dose is defined as the energy applied through the lithographic mask during exposure, expressed for example in mJ/cm². The vertical axis represents the CD, i.e. the critical dimension of the line feature in question, measured on the pattern, for example by CD-SEM.

In theory, the best focus can be determined as the focus setting that minimizes the parabolic curves illustrated in Figure 2. In practice however, this is a complicated and difficult task for a variety of reasons. One problem apparent in Figure 1 is that the minima of the curves are not lying exactly on a vertical line. The main problem however is that the illustrated focus range ΔF is much larger than the practical focus range that is applicable on a scanner tool. In other words, focus settings applied during manufacturing are situated in a narrow range ΔF' centered around the zero-defocus setting of the tool. This narrow range ΔF' is illustrated in Figure 2 by the rectangle 10. Within this range, currently applied calibration methods are based on varying the focus and dose settings on the tool and producing the same pattern multiple times on a so-called FEM (focus-energy matrix) wafer. SEM-based measurements of the CD are performed on the obtained patterns, enabling to determine multiple points of the curves, and to thereby determine the curves by a suitable curve-fitting technique.

A typical result of this process is shown in Figure 3, which shows an enlarged view of the rectangle 10 indicated in Figure 2. The applicable focus range ΔF' is indicated, and the graph includes a number of dose-related curves 11 for a typical pattern feature. Apart from the fact that SEM-based measurements are very time-consuming, the main problem is immediately apparent from Figure 3. In the narrow window 10, the curves 11 are practically horizontal and it is therefore very difficult or impossible to derive the best focus value from these curves. For a majority of the line features of a typical pattern, this is a consequence of the fact that the lithographic mask has been designed specifically so that the feature is produced correctly within the applicable focus range, i.e. the curves are as flat as possible. This makes it difficult however to determine the best focus from these curves.

The way in which these problems are solved today is often by trying to improve the precision of the SEM-based CD measurements, such as by performing this measurement multiple times and averaging the result. However, this approach further increases the calibration time, and it doesn't change the basic problem, namely the fact that a maximum or minimum is not clearly identifiable on the majority of the curves, within the focus range of interest. Apart from measuring the CD, other pattern attributes are often determined on the SEM images, such as LER, LCDU and SDD. The measurement of these attributes is however difficult and very labourintensive, which further adds to the excessive time needed for making these evaluations.

The invention will now be described on the basis of a number of preferred embodiments.

In the following and in the appended claims, reference is made to a 'resist pattern' or 'printed pattern' and to an 'etched pattern'. The terms resist pattern and printed pattern refer to a pattern obtained after the illumination of a resist layer through a lithographic mask and after the removal of illuminated or non-illuminated portions of the resist, depending on the type of resist (positive or negative). An etched pattern refers to the pattern of a layer underlying the resist, after transferring the resist pattern to said layer by etching, and after removing the resist pattern. The etched pattern is therefore also the 'device pattern' referred to in the appended claims. The method of the invention for optimizing one or more process parameters may be based either on a resist pattern or on an etched pattern or for a number of process parameters on both.

The following text will begin by describing the determination of the best focus setting derived from a resist pattern as a representative embodiment of the parameter optimization achievable by the method of the invention. The description is however applicable to the optimization of several contrast-related parameters other than the focus setting. The optimization (for at least some of the optimized parameters) may furthermore be based on a resist pattern or an etched pattern. These variants will be explained in more detail in a number of closing paragraphs of the detailed description.

According to said exemplary embodiment of the invention, the determination of best focus for producing a given device pattern is based on a metrology target pattern that is printed several times on a resist layer by a lithography process using a lithographic tool such as an EUV scanner, each time applying a different focus setting on the tool, within a predefined focus range.

The use of the metrology target is a generic feature of any embodiment of the invention. The metrology target pattern is designed so that it includes features having design CDs which are offset from a value that is representative of one or more features of the device pattern. Features having said representative CD may equally be included in the target pattern. The target pattern may be printed separately without actually printing the device pattern, i.e. using a mask including only one or a set of metrology targets, or it may be printed together with the actual device pattern, for example included in the lithographic mask used for printing the device pattern.

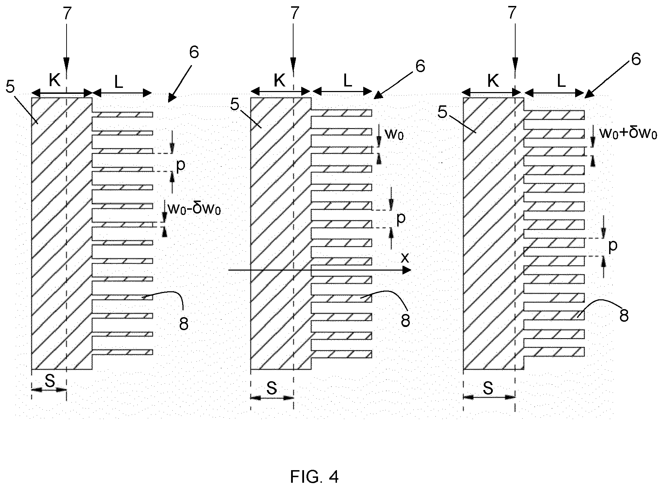

Figure 4 illustrates one possible appearance of a target pattern (hereafter also abbreviated as 'target') applicable in the method of the invention, but other designs and shapes are possible. Such designs and shapes are in fact known and described for example in patent publication document US10824081. The target comprises a plurality of asymmetric marks which may be comb-shaped, as in Figure 4, i.e. each mark comprises a solid rectangular part 5 and a regular array 6 of parallel line-shaped features 8 issuing at a right angle from the solid rectangle 5. The pitch p of the array of line-shaped features, the width K of the solid part 5 and the width L of the array part 6 are the same for the three marks. However, the widths of the line-shaped features, referred to hereafter as the critical dimensions (CD) characterizing the marks, are different in the three marks. For example, the central mark may have a design CD of a reference value w₀, whereas the other two marks have design CDs offset from w₀ by an offset value 5w, i.e. these design CDs are respectively w₀-δw and w₀+δw. The CD value w₀ is representative of the CD of one or more features of the device pattern for which the focus setting is being optimized. For example, w₀ may be close to the CD of a number of features appearing in known hotspots of the device pattern, i.e. areas which are known to be critical, as determined for example during the design stage of the lithographic mask fabricated for producing the pattern. The 'design CDs' are the dimensions for which the mask has been designed, i.e. the values which need to be reproduced as accurately as possible in the resist pattern and the eventual device pattern.

The centroids 7 of the respective marks are also indicated in Figure 4. The centroids are defined as the vertical lines which divide the surface area of the marks in two equal parts. The centroid position therefore shifts from left to right when the CD changes from a lower to a higher value. The position of the centroid 7 may be expressed by the distance S indicated in Figure 4.

The invention makes use of the fact that the relation between the effective mark CDs, i.e. the CDs of the printed or etched mark features, and the design CDs (w₀-δw, w0 and w₀+δw) is an essentially linear relation, i.e. effective CDs measured on the printed or etched mark features can be approximated by a best-fitting linear relationship with respect to the design values, said relationship having a well-defined slope. The fact that this relation is close to linear is known as such and linked to the fact that the focus setting is directly related to the pattern contrast. The invention is based on the realization that the slope of the linear relation is itself a contrast-related parameter that exhibits a much higher sensitivity to contrast than the focus setting (as well as other parameters), and that allows to determine the best setting for a plurality of process parameters, including the best focus setting, in a more accurate and faster way than current methods.

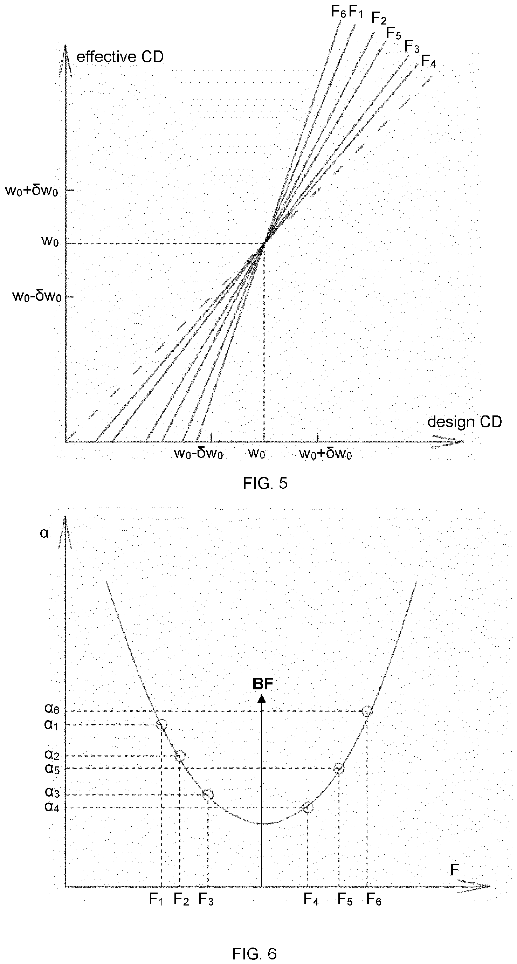

The linear relation between the effective printed mark feature CDs of the target shown in Figure 4, and the design CDs is illustrated in Figure 5 for a number of different focus settings F₁ to F₆, which are all lying within the applicable focus range ΔF' illustrated in Figure 3. These linear relations can be determined by measuring the effective CDs, for example by a CD-SEM measurement and determining the best-fitting line through the measured points. These lines may be characterized as functions *y* = *αᵢx* + *b*, with αᵢ (i=1 ...6) representing the slopes of the respective lines. The dotted line drawn through the origin represents the theoretical case in which all the design CDs are printed 100% correctly, i.e. α = 1.

As the value w₀ is representative of line features of the device pattern for which the focus setting is being optimized, the effective CDs of the line features of the central mark will be very close to their design value w₀ for each of the focus settings F₁ to F₆, because the lithographic mask has been designed in order to have low sensitivity to focus in the applicable focus range, as was illustrated with reference to Figure 3. This is why the lines are all seemingly passing through the point (w₀,w₀) in the graph in Figure 5. In reality the lines do not pass through a geometrically defined single point, but they are close together around the point (w₀,w₀) because of the low sensitivity to focus at the design CD w₀. As seen in Figure 5 however, the slope of the linear relations is much more sensitive to focus within the applicable focus range.

In order to identify the various slope values, it suffices to choose the offset value δw₀ sufficiently high, so that clearly distinguishable linear relations can be identified.

Figure 6 shows the slopes α₁ to α₆ as a function of the focus settings F₁ to F₆. The relation of the slopes to the focus settings can be approximated by a parabolic curve that exhibits a clearly identifiable minimum. This minimum represents the best focus setting for the pattern in question. Mathematically, the best focus can be calculated as the value of F for which the first derivative of the parabolic function is equal to zero. Because the slopes exhibit a higher sensitivity to focus than the CD of a representative feature, this approach enables a much more accurate determination of the best focus. The best-fitting curve is not necessarily a mathematically defined parabola, but it will in any case exhibit a clearly defined minimum, thereby enabling to determine the best focus setting.

According to an embodiment, the slopes α₁ to α₆ (and possibly additional slopes at additional focus settings), are determined by effectively measuring the CDs by a suitable technique like CD-SEM, followed by the determination of the best fitting parabola-shaped curve of the slopes as a function of focus, and the determination of best focus as the minimum of the parabola. The measurement of the CDs on SEM images is however again a time-consuming effort, made more difficult by the fact that for highly out-of-focus settings, the CD is not constant along the length of the line features because of the increasing line edge roughness, illustrated in Figure 1b. The CD must then be determined as an average of several values measured along the length of the features. According to other and more preferred embodiments therefore, the slopes are not determined on the basis of a measurement of the effective CDs but on the basis of a parameter that is proportional to the effective CDs.

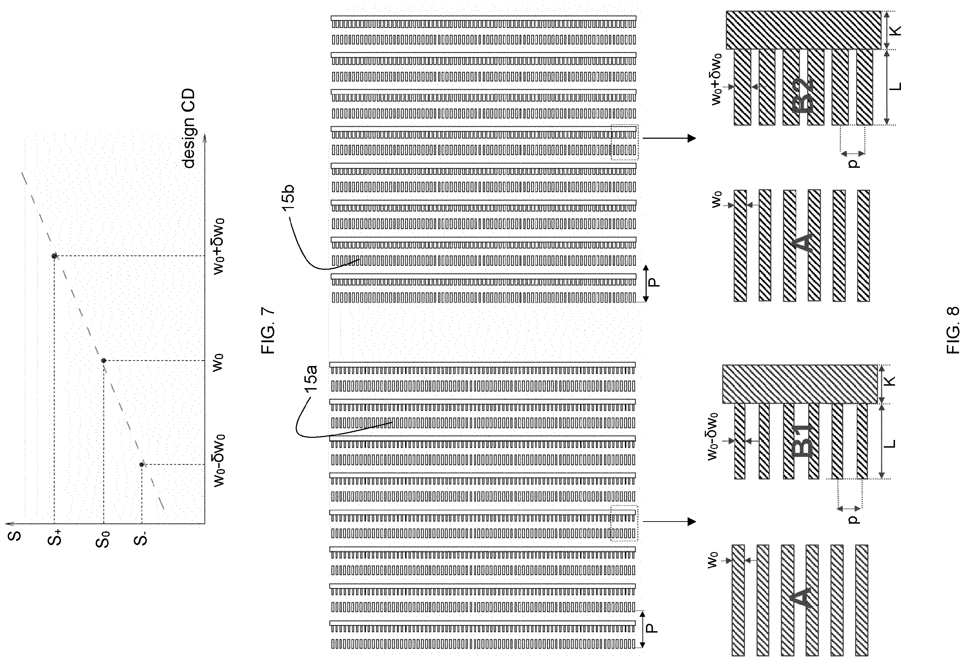

A first embodiment of such a parameter is described in US10824081, and may be referred to as a 'pattern shift response' (PSR). Measuring the PSR is based on the relation between the effective CD of the mark features and the position of the centroid of the printed mark. The centroid 7 was defined and illustrated above with reference to Figure 4. As was established already in US10824081, the centroid position, expressed for example by the distance S shown in Figure 4, and measured on a printed version of the marks, is effectively proportional to the CDs, and therefore also exhibits a linear relationship as a function of the design CDs wo-5w, w₀ and w₀+δw, as illustrated in Figure 7. The slope of this relation may be called α'. As α' is proportional to the slope α, the determination of this slope as a function of focus enables to find the best focus in the same manner as described above.

The area-based centroid position S could be calculated from the measured CDs and the dimensions K and L of the marks, but a faster way is described in US10824081. This concerns the detection by an optical tool, for example an image-based overlay (IBO) tool, of the centroid of an intentionally blurred image of the marks. To this aim, the optical tool is configured so that the pitch of the printed arrays (the comb legs shown in Figure 4) is not resolvable by the tool, i.e. the marks appear as areas having a continuous intensity profile against a contrasting background. The optical tool allows to measure the intensity profiles as a function of the dimension x transversal to the mark patterns (see Fig. 4), and to determine from said profiles the position of the centroid of the unresolved image, which is equal to or at least representative of the actual centroid position of the mark patterns. The image centroid position is obtainable by integrating the light intensity profile and determining the position at which the integrated intensity is the same on either side of said position. This can be done quickly for a variety of focus settings, as it does not require measuring individual CDs. What is required is that the target is suitably designed for enabling the measurement as a function of the different design CDs w₀-5w, w₀ and w₀+δw. Suitable target designs are described in US10824081 and therefore not included in detail in the present description. The parameter S may be defined analogously to the pattern centroids 7 illustrated in Figure 4, i.e. as the distance of the image centroid to the left border of the image in the direction x. S could however be defined in other ways, for example as the distance between the image centroids of two mirrored copies of the same mark.

Another embodiment of the parameter S is obtainable not by an imaging tool but by a measurement of the diffraction of light by a suitably designed target pattern. This is also described fully in US10824081. An exemplary target design is illustrated in Figure 8 and comprises a first and second grating 15a and 15b, which respectively include asymmetric marks B1 and B2 with design CDs of w₀+δw and w₀-δw, arranged with respect to a symmetric mark A having lines of design CD w₀. A diffraction-based overlay tool (DBO) is capable of measuring the difference between the plus and minus first order diffracted intensity of light diffracted by the printed gratings 15a and 15b. As this intensity difference is related to the centroid position of the printed marks, the measurement enables to determine the slope of the linear relation between said centroid position and the design CD. The method and equations required for determining the slope in this way are disclosed in US10824081. The slope can thus be determined for a plurality of focus settings, and the best focus can be derived in the manner described above. Like the embodiment involving the IBO tool, this embodiment does not require measuring individual CDs and therefore enables an accurate as well as a fast determination of best focus.

In any embodiment according to the invention, the target may include two or more different design values, for example by adding marks having design CDs w₀-iδw and w₀+iδw with i an integer equal to 2 or more. It is also possible to determine the slope if the pattern-representative value w₀ is not included in the target, but when only the offset values, for example w₀- δw₀ and w₀+ δw₀ and possibly additional offset values w₀ ± iδw are included in the target.

Another advantage of the invention is that the method for determining best focus is essentially not dependent on the dose applied in the scanner when the various exposures at different focus settings are performed. Parabolic curves like the one shown in Figure 6 and obtained at different dose settings are in fact very close together, because the contrast is primarily dependent on the focus setting and much less on the dose setting. Measurements at different dose settings are therefore not required when the method of the invention is applied.

The above-described method for determining best focus takes place for a given configuration of the lithography process in terms of the conditions other than focus. In other words, only the focus setting is changed while all other conditions (illumination source conditions, resist type, resist development parameter) are the same. Additional information about said additional conditions may be determined from the curvature of the parabolic curve illustrated in Figure 6. Mathematically, this is done by calculating the second derivative of the function corresponding to the best-fitting curve. For example, the value of the second derivative at best focus expresses the sharpness of the curve, and is therefore a measure of the depth of focus, i.e. the range within which line features can be printed according to given specifications. The value of the second derivative at other focus values may be related to certain process parameters, such as the type of resist, resist thickness, exposure times, etc.

Also, the method for determining best focus as described above may be applied at different lithographic process conditions and/or different etch conditions, for example at different illumination source conditions and for different resist types and/or different resist development conditions. Each set of conditions yields a curve like the ones shown in Figure 6, relating the slopes of the linear relationships derived from the target pattern, to the applied focus settings. The assessment of the curvature of these curves can then serve as a basis for selecting preferred illumination and/or resist-related conditions, for example by selecting conditions which minimize the curvature at best focus.

In general terms, the method of the invention can be described as a method for optimizing a primary contrast-related parameter, for example the focus setting, for a given process configuration in terms of illumination, resist, etc. Repeating the optimization for different process configurations then enables optimizing additional parameters relevant to said process configurations.

As stated in the introduction, the invention is not limited to the choice of the focus setting as the primary contrast-related parameter that is being optimized. Any parameter that allows to determine a set of linear relationships as shown in Figure 5, when the parameter is varied within a given range, is defined within the present context as a 'contrast-related parameter' and can therefore be used as the primary optimized parameter in the method of the invention. The expression 'varied within a given range' should be interpreted broadly in the present context, in that it is not limited to numeric parameters varied within a numeric range. For example, the resist type could be chosen as the primary parameter. Even though a parabole-type curve cannot be determined for this parameter, the method still allows to determine the resist type for which the slope in Figure 5 is the lowest, enabling to select that resist type as the one that maximizes the contrast within the given set of resists.

Other examples of parameters suitable as the primary parameter in the method of the invention may include illumination source configurations or resist development and bake conditions. Etch process conditions related to the contrast of the etch pattern can be used as primary parameters for optimizing the etch process.

Some parameters are numeric but may be difficult to control directly. An example of this is the MSD parameter referred to in the introduction. There is no dial on the scanner that allows to set a value for the MSD. However, by changing the overlay error correction setting of the scanner, the MSD can effectively be varied. The overlay setting can then be used as the primary parameter in the method of the invention, which allows to optimize this setting. Due to the known relation between the overlay correction setting and the MSD, the optimized overlay correction setting thereby optimizes the MSD parameter.

In terms of the appearance of the marks, the invention is not limited to the marks shown in Figure 4. Figure 8 shows another asymmetric mark design applicable in the method of the invention. The mark comprises a solid portion 5 and a 2-dimensional array of features 21 defined by critical dimensions CDx and CDy measurable in two orthogonal directions. Marks of this type have also been disclosed in document US10824081 and enable to determine the position of the centroid 7 or a parameter proportional thereto in the same way as described in relation to the marks illustrated in Figure 4. The target applied in this case includes several of these marks, each comprising different design values of CDx and CDy, biased with respect to design values w₀ₓ and w_{0y} which are representative of 2-dimensional pattern features of the pattern for which the optimization is taking place. The linear relations shown in Figure 5 can then be determined for CDx and CDy, and best focus (or other parameter) settings can be determined based on either one of these dimensions, enabling to finally select a setting that optimizes printing or etching the 2-dimensional features in the best possible way.

The method of the invention enables to produce a full 'best focus map' for a production wafer applicable in a semiconductor manufacturing process. A production wafer typically includes a plurality of dies distributed on the surface of the wafer, wherein a plurality of lithography steps is performed consecutively on each die. For each lithography step, the knowledge of the best focus setting is important, but this best focus setting can differ for different positions on the wafer surface, hence for different dies. Nowadays it is virtually impossible to determine the best focus for each die position given the time-consuming methods that are used. The method of the invention, when applied in combination with the optical or diffraction-based metrology tools for determining the slopes of the linear relations shown in Figure 5, enables to determine the best focus in a much faster way compared to current methods. This makes it possible to determine a full 'best focus map' within a realistic timeframe. More generally, a 'best setting map' for any parameter applicable instead of the focus setting can be obtained. When the parabola-type curve is determined at different process configurations, an additional map can be derived showing best settings for one or more additional parameters obtained from minimizing the curvature of said curves.

As stated, the method of the invention can be based on a resist pattern that reproduces the target pattern in a resist layer or on an etched pattern. In both cases, the method is characterized by the same characteristic features, but nevertheless these two options represent clearly distinguished embodiments. When the method is based on the resist pattern, i.e. by measuring CD or centroid-related parameters on said resist pattern, the method enables the optimization of any contrast-related parameter that is related to the lithographic process, i.e. focus setting, illumination conditions, resist type, etc. When the method is based on the etched pattern, the method also enables optimization of lithographic parameters such as focus, because the process for producing the etched pattern necessarily also includes the lithographic process. In addition, optimization of etch-related parameters, such as etch time, type of etchant etc, is enabled when the method is based on the etched pattern.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method for optimizing a process parameter applicable in a process for producing a device pattern of a semiconductor component, the process comprising a lithography step and an etch step, the device pattern comprising device features formed on a substrate, said features being **characterized by** critical dimensions measurable in at least one direction,
the method comprising the steps of :
- providing a lithographic mask that includes at least a metrology target pattern comprising a plurality of asymmetric marks, each mark comprising a solid portion (5) and a pattern portion (6), the pattern portion comprising a regular array of equally dimensioned mark pattern features (8,21) defined by a design CD (critical dimension) measurable in at least one direction, and wherein :
∘ the plurality of marks includes marks having different design CDs, which are offset on one or both sides with respect to a design CD value (w₀, w₀ₓ, w_{0y}) that is representative of one or more features of the device pattern,
∘ the effective CD of the mark features as reproduced in a resist pattern and in an etched pattern produced using said lithographic mask, or any parameter proportional thereto, exhibits a linear relation with respect to said different design CDs,
- reproducing the target pattern on a substrate, for a number of different settings of said process parameter,
- for each setting, determining the slope of said linear relation,
- optimizing the parameter by determining a setting that minimizes the slope.

2. The method according to claim 1, wherein said process parameter is a parameter that can be represented by a numerical value, and wherein the method includes the steps of :
- determining the best-fitting curve that connects the slopes as a function of the different numerical values representing the different applied parameter settings,
- determining a minimum of said best-fitting curve.

3. The method according to claim 2, wherein said process parameter is the focus setting of a lithographic tool used for reproducing the target pattern.

4. The method according to claim 2, wherein said process parameter is the Mean Standard Deviation (MSD), being the differential positioning error induced by desynchronization of the scanner reticle stage to the wafer stage of a lithographic tool used for reproducing the target pattern, and wherein the MSD is varied by varying an overlay correction setting of the lithographic tool.

5. The method according to any one of claims 2 to 4, further comprising determining the curvature of the best-fitting curve in one or more points of the curve, and deriving from said curvature information about process parameters other than the optimized parameter.

6. The method according to claim 5, wherein the optimized parameter is the focus setting of a lithographic tool used for reproducing the target pattern, and wherein the curvature is determined at the best focus setting, and wherein said curvature is a measure of the depth of focus, in the sense that a smaller curvature indicates a higher depth of focus.

7. The method according to any one of claims 2 to 4, wherein :
- said process parameter is optimized for a plurality of sets of process conditions defined by varying one or more process parameters other than said optimized parameter, thereby obtaining a plurality of best-fitting curves corresponding respectively to said sets of conditions,
- the curvature of the best-fitting curves is determined in one or more points of the curves, and
- a selection of optimum conditions is made on the basis of said curvature.

8. The method according to any one of the preceding claims, wherein the target pattern comprises at least one mark comprising an array of features having said design CD value (w₀, w₀ₓ, w_{0y}) that is representative of one or more features of the device pattern.

9. The method according to any one of the preceding claims, wherein the marks include a one-dimensional array of line features (8) defined by a critical dimension measurable in one direction.

10. The method according to any one of claims 1 to 8, wherein the marks comprise a two-dimensional array of features (21) defined by critical dimensions measurable in two orthogonal directions.

11. The method according to any one of the preceding claims, wherein the marks of the target pattern are configured in such a way that the marks as reproduced on the substrate can be viewed by an optical tool, and wherein the slope is determined by the following steps :
- with the optical tool, determining a parameter that is representative of the position of the centroid of the asymmetric marks, said parameter being proportional to the effective CD of the mark features,
- determining the slope as the slope of the linear relation between said parameter and the design CD.

12. The method according to anyone of claims 1 to 10, wherein the marks of the target pattern are arranged in the form of gratings configured so that the marks as reproduced on the substrate are suitable for use as diffraction gratings, wherein the plus and minus first order diffracted intensity of light diffracted by said diffraction gratings is measured, and wherein said slope is calculated from said measured intensities.

13. The method according to any one of the preceding claims, wherein said method is performed on several die locations of a semiconductor process wafer, and wherein a map is produced showing the optimized parameter for each die location on the wafer.

14. The method according to any one of the preceding claims, wherein the optimized parameter is a lithographic process parameter of said lithography step, and wherein the target pattern is reproduced by said lithography step in the form of a resist pattern on the substrate, and wherein the slope is determined by measurements performed on the resist pattern.

15. The method according to any one of claims 1 to 13, wherein the optimized parameter is a lithographic process parameter of said lithography step or an etch process parameter of said etch step, and wherein the target pattern is reproduced by said lithography step followed by said etch step, in the form of an etched pattern on the substrate, and wherein the slope is determined by measurements performed on the etched pattern.
